(19) Europäisches Patentamt / European Patent Office / Office européen des brevets

(11) **EP 4 231 105 A1**

(12) **EUROPEAN PATENT APPLICATION**

(43) Date of publication:
**23.08.2023 Bulletin 2023/34**

(21) Application number: **22157196.1**

(22) Date of filing: **17.02.2022**

(51) International Patent Classification (IPC):
**G05B 19/418** (2006.01)    **H01L 21/67** (2006.01)
**G06K 9/62** (2022.01)    **G06N 3/00** (2023.01)
**G06N 3/08** (2023.01)    **G06N 20/00** (2019.01)
**G06Q 10/04** (2023.01)    **G06Q 10/06** (2023.01)

(52) Cooperative Patent Classification (CPC):
**G05B 19/41865; G06F 18/24323; G06N 3/006;**
**G06N 3/08; G06N 20/00; G06Q 10/04;**
**G06Q 10/0637;** G05B 2219/31407;
G05B 2219/32265; G05B 2219/45031

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **Robert Bosch GmbH**
**70442 Stuttgart (DE)**

(72) Inventors:
• **Janus, Michel**
**72138 Kirchentellinsfurt (DE)**
• **Schelthoff, Kai**
**52064 Aachen (DE)**

Remarks:
Amended claims in accordance with Rule 137(2) EPC.

(54) **METHOD FOR WAITING TIME PREDICTION IN SEMICONDUCTOR FACTORY**

(57)    A computer-implemented method of waiting time prediction (30) for a route comprising a plurality of production operations in manufacturing, comprising the steps of:
Receiving (S31) a sorted list of production operations, wherein the list characterizes the rout for manufacturing a lot;
Determining for each production operation in the sorted list:
Sampling (S32) feature values for a plurality of features by sampling from a database (51) of collected feature values for the operation measured feature values depending on the starting time point;
Predicting (S33) expected waiting time depending on sampled feature values;

Fig. 3

**Description**

The invention concerns a method of waiting time prediction for a route comprising a plurality of production operations in manufacturing and method of training a machine learning system for an expected waiting time prediction of production operations in manufacturing and a computer program and a machine-readable storage medium a system configured to carry out said methods.

Prior art

The context of the invention is in manufacturing, more specifically the planning and prediction of when a product lot will finish processing in manufacturing. Especially in semiconductor manufacturing, where production of one lot can take several weeks to months accurate predictions for completion of production for a given lot are very desirable. Despite the necessity for accurate predictions of completion dates, the industrial state of the art falls behind. It is common to use mean cycle times for those predictions, regardless of the current fab situation. A more elaborated standard method uses the average sojourn time for all process steps in a defined time window to sum them into a cycle time.

Another state-of-the-art solution would be to cover the manufacturing process in a discrete-event simulation, which is then able to predict the cycle time. While this method is in theory as accurate as possible, it comes along with some disadvantages. First, it is time- and capital intensive to build and maintain such a simulation, since the extremely complex production processes have to be understood and digitally modelled in every detail. Furthermore, even when the simulation is available, the execution of it takes a long time, since it is a complex computational problem. Hence, only some scenarios can be executed in a reasonable amount of time, especially when it shall be used for production steering.

There are approaches on waiting time predictions by forecasting models, wherein the forecasting models can be neural networks or data mining models to forecast cycle times.

Chen, T. and Wang, Y.-C. and Lin, Y.-C. and Yang, K.-H., Estimating job cycle time in semiconductor manufacturing with an ANN approach equally dividing and post-classifying jobs, Materials Science Forum, Vol. 594, p. 469-474, disclose exemplarily models for estimating cycle and waiting times in semiconductor fabs.

Advantages of the invention

A goal of this invention is to provide a solution that is more accurate than simple (rolling)-mean predictions but easier to maintain and faster to execute than a full-blown simulation.

The present invention has basically three advantages. First, it is more accurate than mean or rolling mean estimators. Analyses done on operational data have shown that the developed methodology outperforms those estimators in terms of root mean squared error by three days, while predicting the mean cycle time equally well. This effect is even stronger when lots deviate from their mean cycle time. Hence, the mean absolute deviation of the estimation compared to the actual cycle time is seven days more accurate with this methodology when a lot has a cycle time >48 days. Second, it is faster than discrete-event simulations, because no interdependencies have to be modelled. Therefore, a run can be executed within minutes instead of hours, opening possibilities for investigating more scenarios in the same amount of time. Third, the methodology is easy to maintain, because it is built on operation-level and uses only inputs from current production data as well as one prediction model per operation. Hence it is modular in the sense that, when an operation is changed, only the model of this operation has to be retrained, while the rest can remain as it is.

Disclosure of the invention

In a first aspect, a method of waiting time estimation for a route that comprises a plurality of production operations in manufacturing is proposed. The waiting time can be defined as elapsed time between completing the previous operation and starting the next one.

The method starts with receiving a sorted list of production operations, wherein the list characterizes the rout for manufacturing a lot. Thereafter, it follows defining a point in time of a lot production start time.

Then, a loop is carried out for determining for each production operation in the sorted list the expected waiting times. The loop begins with sampling feature values for a plurality of features by sampling from a database of previously collected feature values for the operation measured feature values depending on the starting time point. The features characterize a property and/or state the lot and/or a property and/or state of a factory for manufacturing the lot. The second step of the loop relates to predicting expected waiting time depending on the sampled feature values.

The predicting expected waiting times are accumulated over the operations. Optionally, the accumulated expected waiting time are outputted as a total waiting time for the route.

Advantageously, no information about process flows of other lots are considered, which leads to the reduced calculation time compared to discrete-event-simulations.

It is proposed that the sampling of feature values is either carried out by random sampling of collected feature values from the database, or by determining the feature values by an average of collected feature values from the database, or by determining the feature values by a rotating average of collected feature values from the database, wherein the collected feature values of the database have been collected for operations carried out in the past.

Furthermore, it is proposed that the predicted waiting times are predicted by means of a trained machine learning system, wherein the machine learning system receives as input the feature values and outputs the expected waiting time.

Furthermore, it is proposed that there is a plurality of trained machine learning systems, wherein each machine learning system is assigned to one of the production operations and each machine learning system has been trained to predict the expected waiting time for its assigned production operation depending on its input feature. Preferably, the machine learning system take as inputs different feature sets. This means that the inputs of the respective machine learning system can be actively reduced to a set of necessary features.

Furthermore, it is proposed that the sorted list of operations of the route is determined based on historic probabilities of said route. The database comprises a plurality of previously tracked routes and thereof correspondingly collected feature values and waiting times and preferably processing times of the operations of the tracked routes. Based on a probabilistic distribution of said tracked routes, the historic probabilities can be determined to estimate a set of operations carried out for said route. The historic probabilities can be probabilities that characterize the probability of the lot for choosing said route based on previously measured data in the database.

Furthermore, it is proposed that in addition to the expected waiting time also an expected processing time of the respective operation is determined depending on the sampled feature values, wherein also the expected production times are accumulated, wherein preferably a cycle time is calculated by summing the accumulated expected waiting with the accumulated expected processing times. Preferably, the trained machine learning system or the plurality of trained machine learning systems are configured to additionally output the expected processing times.

In a second aspect of the invention, a method of training the machine learning system for predicting an expected waiting time of production operations in manufacturing is proposed.

The method starts with providing training data, wherein the training data comprise a plurality of manufacturing routes of a lot, wherein for each production operation of the routes feature values are collected and corresponding waiting times of the lot are measured, wherein the features characterize a property and/or state the lot and/or a property and/or state of a factory for manufacturing the lot.

Then a training of the machine learning system on at least a first part of the training data is carried out. Known training methods for machine learning systems can be applied. The training is applied such that the machine learning model outputs the measured waiting times depending on the inputted features. Additionally, the training can be configured to train the machine learning system to also output the expected processing time, if the training data also comprise collected processing times of the lot.

Then, a relevance for each feature is determined by discarding the respective feature as input for the machine learning system and measuring the relative performance decrease of the machine learning system for the waiting time prediction with said manipulated input. It follows a ranking the features according to their relevance and testing the ranked features stepwise for a minimal set of the ranked features under the objection that the accuracy of the outputted expected waiting time is not degraded, wherein the evaluation is carried out a third part of the training data. The advantage thereof is that the feature set can be reduced significantly, while the prediction performance remains equal.

It is proposed that the relevance is determined by a permutation feature importance algorithm.

Furthermore, it is proposed that an optimal subset of features is then chosen by a sequential backward search based on the determined relevance of the features.

Furthermore, it is proposed that after training, the machine learning system, the trained machine learning system is evaluated on a second part of the training data and if the model performance is below a predefined threshold, the step of training is carried out again.

Furthermore, it is proposed that a hyperparameter optimization of the machine learning systems is carried out on a part of the training data that has not been used for the training of the machine learning systems.

Furthermore, it is proposed that there are a plurality of different production operations and a plurality of different products, wherein for each combination of production operation and product a machine learning system is trained. This has the advantage that an easy maintenance of the approach is provided in case of an amendment or replacement of a production operation or product. Because then, only the corresponding machine learning system has to be retrained.

Furthermore, it is proposed that the method of the first and second aspect of the invention is applied for waiting time estimation of operations in high product-mix / low-volume semiconductor manufacturing fabs.

Furthermore, it is proposed for the first and second aspect that the lot is an electronic device, in particular an industrial or automotive controller, or a sensor, a logic device or a power semiconductor.

Furthermore, it is proposed for the first and second aspect that the production operations are semiconductor manufacturing operations, in particular diffusion and lithography operations or preferably sub steps of manufacturing operations.

Furthermore, it is proposed for the first and second aspect that depending on the accumulated expected waiting times or determined cycle time, equipment for the production operation of the factory for manufacturing the lot is controlled or a priority of the lot is adapted depending on its waiting time. The advantage is a better utilization rate and control of the factory.

Furthermore, it is proposed for the first and second aspect that depending on the accumulated expected waiting times or determined cycle time an optimal mix of different lots is determined or depending on the accumulated expected waiting times or determined cycle time point in time for when the production of the lot is completed is predicted. By this kind of controlling of the factory, the material waste etc. can be optimized.

Furthermore, it is proposed for the first and second aspect that depending on the accumulated expected waiting times or determined cycle time the lot of a plurality of lots with the lowest or highest waiting or cycle time is further processed or an optimization of a sequence of the operations of the routes to minimize a total waiting of the lots is carried out.

Embodiments of the invention will be discussed with reference to the following figures in more detail. The figures show:

Figure 1    a table of features;

Figure 2    a table of hyperparameters;

Figure 3    a flow chart for training a machine learning system;

Figure 4    a flow chart for applying the machine learning system;

Figure 5    a training system the machine learning system.

Description of the embodiments

Semiconductor manufacturers are faced with increasing customer requirements regarding demand, functionality, quality, and delivery reliability of microchips. This constantly growing market pressure necessitates accurate and precise performance estimation for decision-makers to enter delivery commitments with customers. One significant performance measure is waiting time, which frequently accounts for the highest proportion of cycle time and contributes the most to its variance.

While there are many studies which predict cycle time, we prefer to address waiting time as the variable of interest and allow the practitioner to decide how they want to estimate processing times (i.e. deterministic or stochastic).

To obtain the accumulated total waiting time in a semiconductor fab, one could conduct individual predictions for each operation and sum them up for the entire production cycle of a lot.

Predicting waiting times is, however, a non-trivial task since numerous potentially important influencing features must be considered.

Prediction models that consider a great variety of features are computationally extensive and prone to overfitting while, in contrast, basic models fail to provide valuable predictions. Consequently, semiconductor manufacturers are confronted with the task of identifying the relevant feature set for waiting time prediction.

Furthermore, semiconductor manufacturers are confronted with a volatile demand for a plethora of products. Consequently, semiconductors are produced in so-called (HMLV) semiconductor wafer factories.

In a HMLV wafer fab, the product mix, available technologies, and production capacities constantly evolve over time and a multitude of operations are processed simultaneously on heterogeneous tool sets. Therefore, the requirements for concise and lightweight forecasting models for performance measures increase. This complex production environment implies a multitude of additional features correlated with the waiting time, but so far it is unclear how these features contribute to the forecast quality.

Even though a machine is shown as available in the Manufacturing Execution System (MES), the process quality may not be guaranteed due to machine deterioration. This is a further reason that the prediction of the waiting time is a highly complicated process due to the re-entrant flows, the different layers, the limited machine capacities and complex process flows.

To address this problem, we present a framework for waiting time estimation of operations in semiconductor wafer fabs, preferably HMLV fabs, and introduce a selection framework to determine significant prediction features and produce lightweight models for waiting time prediction. More precisely, we propose a method to predict single waiting times per lot and operation at the point of the completion of the previous operation. We demonstrated the method with real operational data from two production areas, namely Lithography and Diffusion.

It is well known that cycle time is one of the most relevant performance measures for semiconductor manufacturing processes. Cycle time can be defined as elapsed time between starting and completing a task, which is composed of transport time, waiting time, processing time, and time for additional steps.

The Manufacturing Executing System (MES) of a fab tracks Move-In and Move-Out times of each machine (that is, start and end of each processing step). After completing the previous task, the lots enter the joint waiting room of the tool group of the next processing step and wait to be processed. Note that the waiting room is not physically co-located to the tool group and upon arrival of a lot, it is not determined which machine will process the lot. Consequently, the waiting times can also include transport times between the tool groups. The dispatching strategy of the waiting room is dependent on various factors, not FIFO.

In previous approaches, processing times were assumed to be constant for a given processing step. However, in our use case, the processing times are found to be subject to some fluctuations. Nevertheless, the fluctuation of the waiting time outreaches the processing time's fluctuation by far. Therefore, in this approach, our focus is on analyzing and forecasting the waiting times, while the behavior of the processing time in the past is used as an independent variable. In a further embodiment, also the processing times can be predicted.

We define the dependent variable of our models to be the expected waiting time per lot at a given tool group upon arrival at the tool group at $t_0$.

The proposed approach can be distinguished in two parts. First, we identify the feature set for our approach. Second, we propose a feature importance calculation methodology, where a set of features and the best-performing model for the respective problem scope are selected based on a sequential backwards search, which is initialized with the respective permutation feature importance (PFI) values.

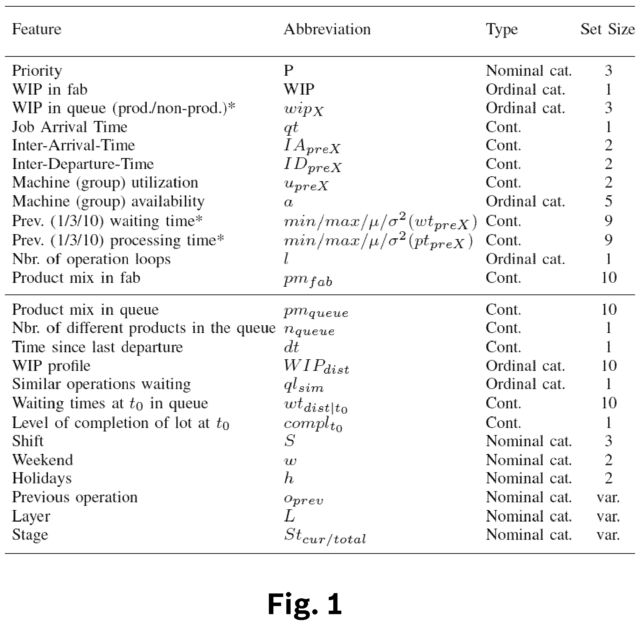

In Fig. 1, the table shows the feature set of our approach. The feature set indicates the manifold of this feature, either for nominal categoricals (nominal cat.), which have to be one-hot-encoded, or for ordinal categoricals (ordinal cat.) and continuous (cont.), which are often times collections of features. The listed features are just exemplarily.

In the following, each feature is briefly explained, including its possible importance and adaption mechanics if necessary.

a. Lot priority (P): Each lot is assigned a priority at fab entry. This priority refers to an importance and urgency of the lot, which is especially important for scheduling during manufacturing and therefore considered as an influencing feature.

b. Work-in-progress *(WIP):* The *WIP* is defined as the number of lots currently in operation in a machine group and the number of lots currently waiting in front of the machine group. Since there exist productive and non-productive lots, i.e. lots used for testing and maintenance purposes, the WIP for all jobs can be calculated for productive lot types ($wip_p$) and for non-productive lot types ($wip_{\{np\}}$) individually. The resulting total WIP in the machine group equals the sum of both features but is not used as a feature to avoid redundant information. Additionally, the WIP of the total fab (WIP) can be considered.

c. Arrival time in the day *(qt):* It is of relevance for batch-building (group of lots to be processed together) operations, in which rate other lots arrive or depart.

d. Inter-arrival *(IA)* and inter-departure times *(ID):* Let $at_l$ be the time of the arrival and $dt_l$ the time of the departure of lot *l. IA* and *ID* are defined as the time between the arrival/departure of the current and the previous lot of the same operation type:

$$IA_l = at_l - at_{l-1}$$

$$ID_l = dt_{l-1} - dt_{l-2}$$

The order of the lots is defined by the corresponding arrival timestamp. For batch operations, it is of importance in which frequency other lots arrive. For both features, the last inter-arrival ($IA_{pre1}$) and inter-departure time ($ID_{pre1}$) as well as the rolling average of the last 10 values ($I_{Apre10}$; $ID_{pre10}$) are utilized as features.

e. Utilization of machine groups (u): For each machine m in machine group *M* (e.g. all Lithography equipment) there is an available processing time ($ca_{(t/m)}$) and an occupied time ($cu_{(t/m)}$) in a defined time window $t = t_0 - x$ to $t_0$, e.g. an hour. They can be expressed as follows, with M as group of machines capable to process o:

$$ca_{(t|M)} = \textstyle\sum_{m \in M} ca_{(t|m)}$$

$$cu_{(t|M)} = \textstyle\sum_{m \in M} cu_{(t|m)}$$

f. The utilization ($u_{preH}$) is the share of the occupied time on the available processing time:

$$u_{preX} = \textstyle\sum_{t=-X}^{t_0} \big(cu_{(t|m)}\big)/\big(ca_{(t|m)}\big)$$

The utilization of the equipment's indicates the available capacity for the process execution. We obtain both, the utilization in the past hour ($u_{preH}$) as well as in the past day ($u_{preD}$) to indicate recent developments in the utilization of the equipments.

g. Availability of machines ($\alpha$): the availability is defined by the number of available machines which are able to execute the operation. Preferably, we obtain the number of machines in each equipment state ("available", "repair", "maintenance", "setup", and "shutdown") as features in order to enable learning on the composition of the machine states in the machine group and its consequences on the waiting time.

h. Processing time ($pt_{preX}$) and waiting time ($wt_{preX}$): we split up the cycle time to acknowledge the fact that both values do not share the same distribution. Additionally, we indicate both values of the last finished operation, of the previous 3 and of the previous 10 recently finished operations of the same product-operation-combination, because it could help to indicate recent trends in both values. Since these features vary (except for the very previous waiting and processing time), the minimal (*min*) and maximal *(max)* value, the mean ($\mu$) and the variance ($\sigma^2$) of *wt* and *pt* are added as features.

i. Product mix in the fab ($pm_{fab}$): An increasingly complex product mix is more challenging and therefore further increases the planning complexity. Since increased complexity impacts the performance of dispatching algorithms, it can be used as an indicator of the stress level of production planning, in combination with the overall fab WIP. The complexity of a product can be measured by the amount of layers necessary for its completion. Hence, we indicate the product mix by the deciles of layers necessary for the completion of all products in the fab at arrival time, as well as of all lots in the queue of the equipments which are capable of executing the operation.

j. Number of tool loops (*l*): This feature indicates whether an operation is executed for the first time, or is repeated as a rework step. The underlying assumption is that a rework step could get urgent or could get extra attention from planners, since it is an unforeseen event.

k. Product mix in the queue ($pm_{queue}$): Despite of the aforementioned $pm\_(fab)$, we conduct this feature using the same calculation pattern. Similar to $pm_{fab}$, $pm_{queue}$ is an indicator of the planning complexity of the machine group and may be of interest in highly sequence-dependent production areas, because it indicates the heterogeneity of a queue. Hence, it might be of relevance for waiting time estimations.

l. Number of different products in the queue ($n_{queue}$): It may be of importance in areas with sequence-dependent setup times, since a heavy variety of products may lead to increased setup times and therefore higher waiting time.

m. WIP profile ($WIP_{dist}$): This feature is a measurement of the level of completion of all lots in the fab at $t\_0$. It can be calculated as the fraction of completed layers and all necessary layers of a lot. Instead of treating all lots of the current WIP equally, we can value each lot by the number of layers to be applied. The feature can be obtained as the percentage of layers completed in relation to the total number of layers to be applied by the recipe of all lots. We introduce the WIP profile as deciles for the whole fab as well as for lots in the queue of the machine group. Products which are close to completion (that is, products which have a high WIP profile value) are likely to be preferred by the dispatching algorithm as its completion is directly influencing the output of the fab, which is a key performance metric.

n. Level of completion ($compl_{t_o}$): This feature indicates the fraction of layers already completed and the total amount of layers of the lot we are currently predicting. With this feature on can acknowledge the importance of the completion level not only for all concurring lots, but also for the lot to be predicted.

o. Amount of similar operations in the queue ($ql_{sim}$): Similar operations are of the same operation type (independent of its product) and can be therefore produced in batches, if the equipments are capable of processing batches. Hence, a lot could be preferred if a lot of similar operations is waiting for execution to create full batches.

p. Waiting times of all lots waiting in the queue at $t_0$ ($wt_{(dist|t_0)}$): In order to keep a fixed shape of input features, we group the waiting lots in the queue into deciles of waiting times. This feature is used to extract further information about the queue participants.

q. Shift at $t_0$ (S): e.g. early: 6:00-14:00, late: 14:00-22:00 and night: 22:00-6:00. Additionally, weekend at $t_0$ (w): 1 if lot enters the queue on a weekend, else 0. Holidays (h): 1 if lot enters the queue during national holidays of the fab location, else 0. We assume that personal resources differ between shifts, weekends and holidays.

r. Previous operation ID ($o_{prev}$): This categorical feature is introduced, since in our use case, the transportation time is included in the waiting time. We assume that it can work as an estimator for the distance to be transported within the fab.

s. Time span since the last departure of a product with the same operation (dt): This feature indicates whether an operation is executed regularly, rarely or if the operation is new. The underlying assumption is that the production efficiency is higher for high-runner products.

t. Layer (L) and stage ($St_{cur}$) of the current operation: This feature indicates the lot's position in the fab. These features might be of interest since products are treated differently when they are close to completion or facing a capital-intensive stage or layer.

u. Number of total stages necessary ($St_{total}$) for completion: This feature shall indicate how complex the respective lot is, assuming that more complex products shall be of higher priority in certain dispatching situations.

The proposed feature selection process is composed of three steps which are executed for each product-operation-combination referred to as Feature Selection Framework herein.

The following approach has been derived from a combination of a permutation feature importance calculation and a sequential backwards search based on the permutation feature importance values. The data set for each part-operation-combination is divided in a training (e.g. 50%), a test (25%), and a validation set (25%) by a random split. In the setup phase of this approach, we compared the results using a random split with a time-dependent split. The results were comparable, but since the data set contains different value ranges over time, we decided to work with a random split.

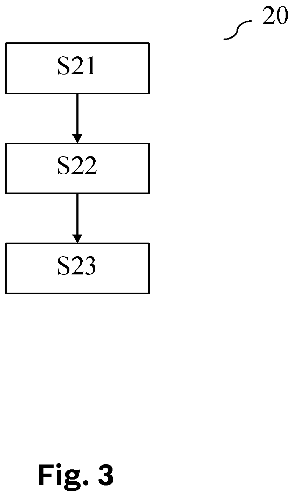

Fig. 3 shows schematically the training procedure.

For each product-operation-combination, we first train (S21) a random forest classifier with the training data set and preferably execute hyper-parameter tuning using the test set. In the set-up phase of this approach, also other modeling techniques (e.g. Multi layer Perceptrons, Recurrent Neural Networks) can be alternatively utilized, and the results show to be comparable.

The input of the model are the features values. In one embodiment, the random forest receives all features values of the features discussed above. In another embodiment, the random forest receives a plurality of the features discussed above. The random forest is configured to predict a value which characterizes the expected waiting time. Additionally, the random forest can also predict a production time for its corresponding operation.

We trained said model for each product operation-combination as the so-called baseline model, using all previously introduced features. Second, we evaluate the performance of the baseline model on the validation set in order to ensure that the model is evaluated on unseen data. Note that preferably baseline models with a sufficient performance score (e.g. the coefficient of determination, which indicates how well the predictions cover the variation of the target values on a scale from 0 to 1) are used for feature selection and the other models with low predicting capability are erased from further analysis.

In the third step, a Permutation Feature Importance (PFI) based feature reduction is executed (S22) for each model. For more information about permutation feature importance: Altmann, Andre, et al. "Permutation importance: a corrected feature importance measure." Bioinformatics 26.10 (2010): 1340-1347.

A model with optimized hyper-parameters is preferably trained with only the identified relevant features. Finally, one can evaluate the performance of the optimized model of a given part-operation-combination against the corresponding baseline model on the validation set.

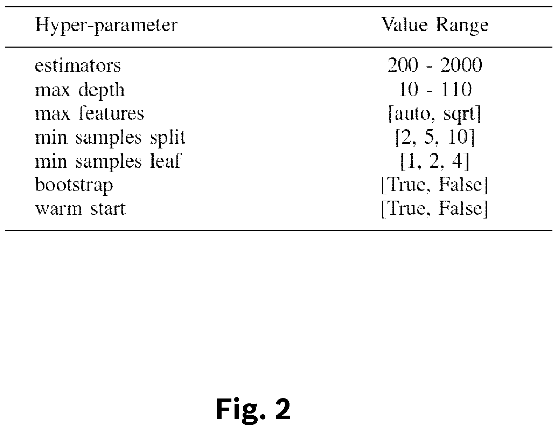

In the following, the training of the Baseline Model is described. The optimal set of hyper-parameters can be chosen by a grid search. Possible boundaries of the grid search can be seen in the table of Fig. 2. The hyper-parameters optimized are described in the following, all other parameters of the method should be left at default values.

A random forest is built alongside various hyper-parameters. First, the number of estimators determines the number of decision trees within the random forest. Second, the max_depth determines the maximum allowed depth of each decision tree. Third, the max_features determines the number of features to consider when looking for the best split. If it is "auto", then the maximum features are the total number of features. If it is "sqrt", then the square root of the total number of features is chosen.

The hyper-parameter min_samples_split determines the minimum number of samples required to split an internal node. The hyper-parameter min_samples_leaf determines the minimum number of samples required to build a leaf. Hence, splitting points are only considered to be implemented in the tree if it leaves the defined amount of training samples for the other branches. The hyper-parameter bootstrap defines whether bootstrap samples are used for building the trees.

Finally, the hyper-parameter warm_start defines whether the solution of the previous call is reused when building the forest, or if a whole new forest is fitted.

In the following, the baseline model evaluation is described. Since we face a regression problem, we evaluate the model performance based on the coefficient of determination ($R^2$). Let $\bar{y}$ denote the mean of $n$ observations

$$\bar{y} = \frac{1}{n}\sum_{i=1}^{n} y_i$$

, and $f_i$ the corresponding prediction of the random forest baseline model. $R^2$ is defined as one minus the share of the explained sum of squares ($SS_{res}$) in the total sum of squares ($SS_{tot}$):

$$R^2 = 1 - \frac{SS_{res}}{SS_{tot}} = 1 - \sum_i (y_i - f_i)^2 \ / \sum_i (y_i - \bar{y})^2$$

Hence, $R^2$ for a given model is 1, if all estimates $f_i$ equal the observations $y_i$, and 0, if all estimates equal the mean $\bar{y}$.

In the following, we execute a permutation feature importance algorithm, which is then used as a sorter in a sequential backwards search. For more information about sequential backward search: Huang, Nantian, Guobo Lu, and Dianguo Xu. "A permutation importance-based feature selection method for short-term electricity load forecasting using random forest." Energies 9.10 (2016): 767.

Starting with the described baseline model and its performance s, for each feature j, the values in the data set are randomly permuted K-times and the resulting model performance $s_{kj}$ is computed. We deploy the aforementioned coefficient of determination $R^2$ as performance measure $s_{kj}$. The importance $i_j$ of feature j is defined as the resulting decrease in the model performance by this shuffle:

$$i_j \ = \ s - \frac{1}{K}\sum_{k=1}^{K} s_{kj}$$

To reduce the influence of random fluctuations in PFI, this process can be carried out K = 1000 times for each feature in every model.

Afterwards, to identify (S23) the optimal feature set for a given problem, we use a sequential backward search as proposed by Huang et al. 'A permutation importance-based feature selection method for short-term electricity load forecasting using random forest', in Energies, Vol. 9, Nr. 10, p.767, 2016}, where the PFI is used as a sorter.

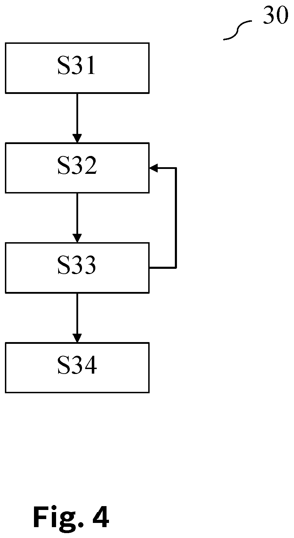

Figure 4 shows schematically a flow chart (30) of an application of the trained models according to Fig. 3.

The method starts with receiving (S31) of a sorted list of production operations and defining time point (t) of a lot production start time.

Then, a loop for determining of the waiting time for each production operation in the sorted list is carried out.

The first step of the loop is a sampling (S32) of feature values for a plurality of features by sampling from a database (51) of collected feature values for the operation measured feature values depending on the starting time point. The second step of the loop comprises predicting (S33) the expected waiting time depending on sampled feature values.

Finally, the expected waiting time of each operation are accumulated (S34).

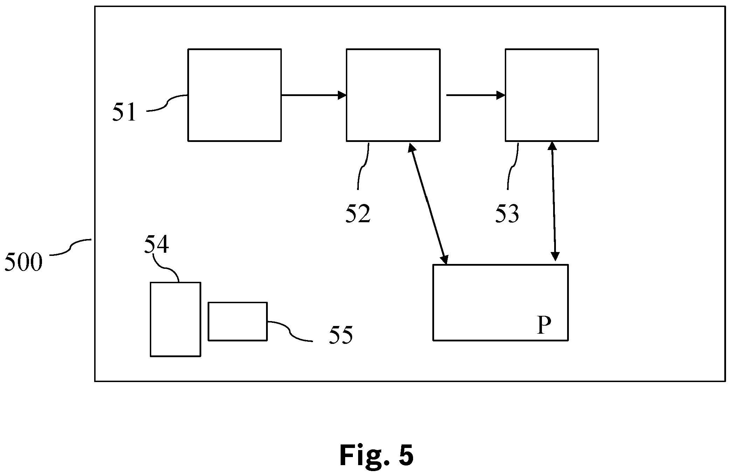

Shown in figure 5 is an embodiment of a training system 500. The training system 500 comprises a provider system 51, which provides input features from a training data base. Input features are fed to the machine learning system 52 to be trained, which determines expected waiting time from them. Expected waiting times and measured waiting times are supplied to an assessor 53, which determines acute hyper/parameters for the machine learning system 52 therefrom, which are transmitted to the parameter memory P, where they replace the current parameters. The assessor 53 is arranged to execute steps S21 of the method according to Fig. 3.

The procedures executed by the training device 500 may be implemented as a computer program stored on a machine-readable storage medium 54 and executed by a processor 55. In a further embodiment, the computer program can comprise instructions to carry out the method of Fig. 4 with the trained machine learning system 52.

The term "computer" covers any device for the processing of pre-defined calculation instructions. These calculation instructions can be in the form of software, or in the form of hardware, or also in a mixed form of software and hardware.

It is further understood that the procedures cannot only be completely implemented in software as described. They can also be implemented in hardware, or in a mixed form of software and hardware.

**Claims**

1. A computer-implemented method of waiting time prediction (30) for a route comprising a plurality of production operations in manufacturing, comprising the steps of:

   Receiving (S31) a sorted list of production operations, wherein the list characterizes the rout for manufacturing a lot;
   Defining time point (t) of a lot production start time;
   Determining for each production operation in the sorted list:

   (1) Sampling (S32) feature values for a plurality of features by sampling from a database (51) of collected feature values for the operation measured feature values depending on the starting time point, wherein the features characterize a property and/or state the lot and/or a property and/or state of a factory for manufacturing the lot;
   (2) Predicting (S33) expected waiting time depending on sampled feature values;

   Accumulating (S34) the expected waiting time of each operation.

2. The method according to claim 1, wherein the sampling of feature values is either carried out by randomly sampling of collected feature values from the database (51), or by determining the feature values by an average of collected feature values from the database (51), or by determining the feature values by a rotating average of collected feature values from the database (51), wherein the collected feature values of the database (51) have been collected for operations carried out in the past.

3. The method according to claim 1 or 2, wherein the predicted waiting times are predicted by means of a trained machine learning system (52), wherein the machine learning system (51) receives as input the feature values and outputs the expected waiting time.

4. The method according to claim 3, wherein there are a plurality of trained machine learning systems, wherein each machine learning system is assigned to one of the production operations and each machine learning system has been trained to predict the expected waiting time for its assigned production operation depending on its input feature.

5. The method according to any of the preceding claims, wherein the production operations are semiconductor manufacturing operations, in particular diffusion and lithography operations.

6. The method according to any of the preceding claims, wherein the lot is an electronic device, in particular an industrial or automotive controller, or a sensor, a logic device or a power semiconductor.

7. The method according to claim 1 or 2, wherein the sorted list of operations of the route is determined based on historic probabilities of said route.

8. The method according to any of the preceding claims, wherein in addition to the predicting expected waiting time also an expected processing time of the respective operation is determined depending on sampled feature values, wherein also the expected production times are accumulated, wherein a cycle time is calculated by summing the accumulated expected waiting and the accumulated expected processing times.

9. The method according to any of the preceding claims, wherein depending on the accumulated expected waiting times, equipment for the production operation of the factory for manufacturing the lot is controlled or a priority of the lot is adapted depending on its waiting time.

10. The method according to any of the preceding claims, wherein depending on the accumulated expected waiting times for different product mix scenarios, an optimal mix of different lots is predicted.

11. The method according to any one of the preceding claims, wherein the method is applied for waiting time estimation of operations in high product-mix/ low-volume semiconductor manufacturing fabs.

12. Computer program that is configured to cause a computer to carry out the method according to any one of claims 1 to 11 with all of its steps if the computer program is carried out by a processor (55).

13. Machine-readable storage medium (55) on which the computer program according to claim 12 is stored.

14. Apparatus that is configured to carry out the method according to any one of claims 1 to 11.


**Amended claims in accordance with Rule 137(2) EPC.**

1. A computer-implemented method of waiting time prediction (30) for a route comprising a plurality of production operations in manufacturing, comprising the steps of:

   Receiving (S31) a sorted list of production operations, wherein the list characterizes the rout for manufacturing a lot;
   Defining time point (t) of a lot production start time;
   Determining for each production operation in the sorted list:
   **characterized in that**

   (1) Sampling (S32) feature values for a plurality of features by sampling from a database (51) of collected feature values for the operation measured feature values depending on the starting time point (t), wherein the features characterize a property and/or state the lot and/or a property and/or state of a factory for manufacturing the lot, wherein the sampling of feature values is either carried out by randomly sampling of collected feature values from the database (51), or by determining the feature values by an average of collected feature values from the database (51), or by determining the feature values by a rotating average of collected feature values from the database (51),
   wherein the collected feature values of the database (51) have been collected for operations carried out in the past;
   (2) Predicting (S33) expected waiting time depending on sampled feature values, wherein the expected waiting time is predicted by means of a trained machine learning system (52), wherein the machine learning system (51) receives as input the sampled feature values and outputs the expected waiting time;

   Accumulating (S34) the expected waiting time of each operation.

2. The method according to claim 1, wherein there are a plurality of trained machine learning systems, wherein each machine learning system is assigned to one of the production operations and each machine learning system has been trained to predict the expected waiting time for its assigned production operation depending on its input feature.

3. The method according to any of the preceding claims, wherein the production operations are semiconductor manufacturing operations, in particular diffusion and lithography operations.

4. The method according to any of the preceding claims, wherein the lot is an electronic device, in particular an industrial or automotive controller, or a sensor, a logic device or a power semiconductor.

5. The method according to claim 1, wherein the sorted list of operations of the route is determined based on historic probabilities of said route.

6. The method according to any of the preceding claims, wherein in addition to the predicting expected waiting time also an expected processing time of the respective operation is determined depending on sampled feature values, wherein also the expected production times are accumulated, wherein a cycle time is calculated by summing the accumulated expected waiting and the accumulated expected processing times.

7. The method according to any of the preceding claims, wherein depending on the accumulated expected waiting times, equipment for the production operation of the factory for manufacturing the lot is controlled or a priority of the lot is adapted depending on its waiting time.

8. The method according to any of the preceding claims, wherein depending on the accumulated expected waiting times for different product mix scenarios, an optimal mix of different lots is predicted.

9. The method according to any one of the preceding claims, wherein the method is applied for waiting time estimation of operations in high product-mix/ low-volume semiconductor manufacturing fabs.

10. Computer program that is configured to cause a computer to carry out the method according to any one of claims 1 to 9 with all of its steps if the computer program is carried out by a processor (55).

11. Machine-readable storage medium (55) on which the computer program according to claim 10 is stored.

12. Apparatus that is configured to carry out the method according to any one of claims 1 to 9.

| Feature | Abbreviation | Type | Set Size |
|---|---|---|---|
| Priority | P | Nominal cat. | 3 |
| WIP in fab | WIP | Ordinal cat. | 1 |
| WIP in queue (prod./non-prod.)* | $wip_X$ | Ordinal cat. | 3 |
| Job Arrival Time | $qt$ | Cont. | 1 |
| Inter-Arrival-Time | $IA_{preX}$ | Cont. | 2 |
| Inter-Departure-Time | $ID_{preX}$ | Cont. | 2 |
| Machine (group) utilization | $u_{preX}$ | Cont. | 2 |
| Machine (group) availability | $a$ | Ordinal cat. | 5 |
| Prev. (1/3/10) waiting time* | $min/max/\mu/\sigma^2(wt_{preX})$ | Cont. | 9 |
| Prev. (1/3/10) processing time* | $min/max/\mu/\sigma^2(pt_{preX})$ | Cont. | 9 |
| Nbr. of operation loops | $l$ | Ordinal cat. | 1 |
| Product mix in fab | $pm_{fab}$ | Cont. | 10 |
| Product mix in queue | $pm_{queue}$ | Cont. | 10 |
| Nbr. of different products in the queue | $n_{queue}$ | Cont. | 1 |
| Time since last departure | $dt$ | Cont. | 1 |
| WIP profile | $WIP_{dist}$ | Ordinal cat. | 10 |
| Similar operations waiting | $ql_{sim}$ | Ordinal cat. | 1 |
| Waiting times at $t_0$ in queue | $wt_{dist|t_0}$ | Cont. | 10 |
| Level of completion of lot at $t_0$ | $compl_{t_0}$ | Cont. | 1 |
| Shift | $S$ | Nominal cat. | 3 |
| Weekend | $w$ | Nominal cat. | 2 |
| Holidays | $h$ | Nominal cat. | 2 |
| Previous operation | $o_{prev}$ | Nominal cat. | var. |
| Layer | $L$ | Nominal cat. | var. |
| Stage | $St_{cur/total}$ | Nominal cat. | var. |

**Fig. 1**

EP 4 231 105 A1

| Hyper-parameter | Value Range |
| --- | --- |
| estimators | 200 - 2000 |
| max depth | 10 - 110 |
| max features | [auto, sqrt] |
| min samples split | [2, 5, 10] |
| min samples leaf | [1, 2, 4] |
| bootstrap | [True, False] |
| warm start | [True, False] |

**Fig. 2**

EP 4 231 105 A1

20

```
┌─────────────┐
│     S21     │
└─────────────┘
       │
       ▼
┌─────────────┐
│     S22     │
└─────────────┘
       │
       ▼
┌─────────────┐
│     S23     │
└─────────────┘
```

**Fig. 3**

30

```
┌──────────────┐
│     S31      │
└──────────────┘
        │
        ▼
┌──────────────┐
│     S32      │◄───┐
└──────────────┘    │
        │           │
        ▼           │
┌──────────────┐    │
│     S33      │────┘
└──────────────┘
        │
        ▼
┌──────────────┐
│     S34      │
└──────────────┘
```

**Fig. 4**

**Fig. 5**

Europäisches
Patentamt

European
Patent Office

Office européen
des brevets

# EUROPEAN SEARCH REPORT

**Application Number**

EP 22 15 7196

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CHIH-YUAN YU ET AL: "On-Line Learning Delivery Decision Support System for Highly Product Mixed Semiconductor Foundry", IEEE TRANSACTIONS ON SEMICONDUCTOR MANUFACTURING, IEEE SERVICE CENTER, PISCATAWAY, NJ, US, vol. 15, no. 2, 1 May 2002 (2002-05-01), XP011079734, ISSN: 0894-6507 * the whole document * | 1-14 | INV. G05B19/418 H01L21/67 G06K9/62 G06N3/00 G06N3/08 G06N20/00 G06Q10/04 G06Q10/06 |
| A | WANG JUNLIANG ET AL: "A Data Driven Cycle Time Prediction With Feature Selection in a Semiconductor Wafer Fabrication System", IEEE TRANSACTIONS ON SEMICONDUCTOR MANUFACTURING, IEEE SERVICE CENTER, PISCATAWAY, NJ, US, vol. 31, no. 1, 1 February 2018 (2018-02-01), pages 173-182, XP011676360, ISSN: 0894-6507, DOI: 10.1109/TSM.2017.2788501 [retrieved on 2018-01-25] * the whole document * | 1-14 | |
| A | WO 2020/205339 A1 (LAM RES CORP [US]) 8 October 2020 (2020-10-08) * paragraphs [0046], [0058], [0184] * | 1-14 | TECHNICAL FIELDS SEARCHED (IPC) G05B H01L G06N G06K G06Q |
| A | EP 1 640 834 A1 (SIEMENS TECH TO BUSINESS CT [US]) 29 March 2006 (2006-03-29) * claims 1-9 * | 1-14 | |

The present search report has been drawn up for all claims

| Place of search | Date of completion of the search | Examiner |
|---|---|---|
| The Hague | 15 July 2022 | Itoafa, Alex |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 22 15 7196

This annex lists the patent family members relating to the patent documents cited in the above-mentioned European search report.
The members are as contained in the European Patent Office EDP file on
The European Patent Office is in no way liable for these particulars which are merely given for the purpose of information.

15-07-2022

| Patent document cited in search report | | Publication date | Patent family member(s) | | Publication date |
|---|---|---|---|---|---|
| WO 2020205339 | A1 | 08-10-2020 | CN 113874993 | A | 31-12-2021 |
| | | | JP 2022523870 | A | 26-04-2022 |
| | | | KR 20210134823 | A | 10-11-2021 |
| | | | TW 202101138 | A | 01-01-2021 |
| | | | US 2022171373 | A1 | 02-06-2022 |
| | | | WO 2020205339 | A1 | 08-10-2020 |
| EP 1640834 | A1 | 29-03-2006 | EP 1640834 | A1 | 29-03-2006 |
| | | | US 2006079979 | A1 | 13-04-2006 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **CHEN, T. ; WANG, Y.-C. ; LIN, Y.-C. ; YANG, K.-H.** Estimating job cycle time in semiconductor manufacturing with an ANN approach equally dividing and post-classifying jobs. *Materials Science Forum,* vol. 594, 469-474
- **ALTMANN, ANDRE et al.** Permutation importance: a corrected feature importance measure. *Bioinformatics,* 2010, vol. 26.10, 1340-1347

- **HUANG, NANTIAN ; GUOBO LU ; DIANGUO XU.** A permutation importance-based feature selection method for short-term electricity load forecasting using random forest. *Energies,* 2016, vol. 9.10, 767
- **HUANG et al.** A permutation importance-based feature selection method for short-term electricity load forecasting using random forest. *Energies,* 2016, vol. 9 (10), 767